# EUROPEAN PATENT APPLICATION

(11) **EP 3 331 007 A1**
(43) Date of publication of application: **06.06.2018**
(21) Application number: 16202286.7
(22) Date of filing: 05.12.2016
(51) Int. Cl.: H01L 23/495, G01R 33/00

(54) **INTEGRATED CIRCUIT PACKAGE COMPRISING LEAD FRAME**

(71) Applicant: Melexis Technologies SA, 2022 Bevaix (CH)
(72) Inventor: MONTERO, Nyorle Pete, 4024 Biñan (PH); CHEN, Jian, 2220 Heist-op-den-berg (BE); YAZBECK, Dany, 2149 Brot Dessous (CH); BILBAO DE MENDIZABAL, Javier, 8004 Zurich (CH); YAN, Weixun, 8603 Schwerzenbach (CH)
(74) Representative: DenK iP

(57) **Abstract**

The present invention relates to an integrated circuit package (10) comprising a lead frame (1) comprising a plurality of leads and a current conductor forming an electrically conductive path that connects at least two leads (13,14) of the plurality of leads. The package also comprises a semiconductor die (2) comprising an integrated circuit and having first and second opposing surfaces, the first surface being proximate to the current conductor. Each of the at least two leads comprises a groove (4) to locally space the lead away from the semiconductor die in a direction perpendicular to the first surface, in which the groove (4) comprises at least that part of the lead that overlaps the edge of the semiconductor die.

## Description

### Field of the invention

The invention relates to the field of integrated circuit packages. More specifically it relates to an integrated circuit package comprising a lead frame, such as an integrated circuit current sensor in such package comprising a lead frame, and a method for manufacturing such integrated circuit package.

### Background of the invention

Integrated circuit packages, e.g. IC plastic molded packages, that comprise a lead frame are known in the art. A good electrical insulation between the lead frame and the packaged integrated circuit die may be required, e.g. at least at the interface where no intentional electrical connection is provided, e.g. to avoid electrical shorting. In high current and/or high voltage applications, a good electrical insulation may be particularly important, e.g. to provide sufficient safety isolation in the design in order to meet a target high voltage application. For example, a sufficient distance between the lead frame and the integrated circuit die may be required to avoid electrical breakdown of the material insulating the die from the lead frame or partial discharges between the lead frame and the integrated circuit. However, particular applications may also require a small spacing between the lead frame and the die, for example to achieve a low profile height of the package, or to increase the sensed flux of a magnetic field associated with a current flowing through a part of the lead frame with a die component that is sensitive to such magnetic field.

For example, an integrated current sensor may be provided in an integrated circuit package, e.g. in a plastic molded package, in which an electrically isolated current conductor is formed by a metal lead frame structure and a magnetic hall sensing element or magnetic sensor is arranged in a semiconductor die in close proximity to this electrically isolated current conductor.

It is known in the art that safety isolation generally needs to be incorporated in the design of IC packages for high voltage applications, such as in the design of an integrated current sensor in a plastic molded package, e.g. in order to meet the requirements of a targeted high voltage application. For example, the lead frame and the integrated circuits need to be separated from each other by a sufficient distance or an insulator. While the integrated circuit may comprise a passivation layer, e.g. a polyimide passivation, as primary protection, limitations of the production process may prevent that the integrated circuit is entirely covered, e.g. providing only limited protection at the edges of the integrated circuit. Therefore, high voltage partial isolation problems can occur between the lead frame and the edges of the integrated circuits.

In a current sensor known in the art, a current conductor may be positioned at a controlled distance to the magnetic sensor and in a position that is substantially parallel to the magnetic sensor to improve sensitivity. Plastic mold compound and a layer of polyimide passivation or silicon oxide on the surface of the integrated circuit may be used as an insulation medium in between the current conductor and magnetic sensor. The integrated circuit chip may furthermore be connected to the lead frame via soldered metal bumps. In a current sensor known in the art, the distance between the current conductor and the integrated circuit passivation may be about equal to the height of the metal bump connectors. However, due to packaging assembly constraints, the distance between the current conductor and the integrated circuit chip may be compromised because of process variation.

It is also known in the art to provide an underfill material in between the lead frame and the passivation of the integrated circuit. It is furthermore known in the art to apply an adhesive insulating tape between the integrated circuit passivation and the lead frame. However, such additional measures for improving the inherent insulation provided by the on-die passivation may disadvantageously require additional assembly process steps, and thus may increase manufacturing costs.

### Summary of the invention

It is an object of embodiments of the present invention to provide good and efficient means and methods for electrically insulating a current conductor in a lead frame from at least part of an integrated circuit in an integrated circuit package.

The above objective is accomplished by a method and device according to the present invention.

It is an advantage of embodiments of the present invention that a cost effective assembly packaging can be achieved.

It is an advantage of embodiments of the present invention that a cheap solution is provided to obtain a good electrical insulation between a lead frame and an integrated circuit.

It is an advantage of embodiments of the present invention that no direct insulating material, such as an underfill material or polyimide tape material, needs to be applied in addition to an on-chip passivation to obtain a good electrical isolation between a lead frame current conductor and a passivated surface of a packaged integrated circuit.

It is an advantage of embodiments of the present invention that assembly process limitations relating to the application of a passivation layer, e.g. a polyimide passivation, as primary protection on an integrated circuit can be easily overcome without requiring additional processing steps. For example, such limitations may prevent that the integrated circuit is entirely covered with the passivation material, e.g. such that only limited protection is obtained by the passivation material at the edges of the integrated circuit.

It is an advantage of embodiments of the present invention that high voltage partial isolation problems occurring between the lead frame and the edges of the integrated circuit can be prevented, avoided and/or alleviated, e.g. it is an advantage that partial discharges between the lead frame and the integrated circuit can be avoided and/or reduced.

In a first aspect, the present invention relates to an integrated circuit package comprising a lead frame having a plurality of leads and having a current conductor forming an electrically conductive path connecting at least two leads of the plurality of leads. The package also comprises a semiconductor die comprising an integrated circuit and having first and second opposing surfaces, the first surface proximate to the current conductor and the second surface distal from the current conductor. Each lead of the at least two leads comprises a groove to locally space the lead away from the semiconductor die in a direction perpendicular to the first surface, in which the groove comprises at least that part of the lead that overlaps the edge of the semiconductor die.

In an integrated circuit package in accordance with embodiments of the present invention, the groove may have a V-shaped or U-shaped profile along the longitudinal direction of the lead.

In an integrated circuit package in accordance with embodiments of the present invention, the groove may be formed by a reduced height of the lead relative to the height of the lead outside the groove.

In an integrated circuit package in accordance with embodiments of the present invention, a top surface of each of the at least two leads may be indented such as to form the groove, in which this top surface is proximal to the semiconductor die.

In an integrated circuit package in accordance with embodiments of the present invention, each of the at least two leads may be offset in the groove, relative to the lead outside the groove, over a predetermined distance, e.g. at least 10 micrometers, in the direction perpendicular to the first surface.

In an integrated circuit package in accordance with embodiments of the present invention, the semiconductor die may further comprise a passivation layer on said first surface.

In an integrated circuit package in accordance with embodiments of the present invention, the passivation layer may comprise a polyimide passivation layer.

In an integrated circuit package in accordance with embodiments of the present invention, the integrated circuit package may be a current sensor, in which the integrated circuit of the semiconductor die comprises a magnetic field sensing circuit. The magnetic field sensing circuit may be adapted for sensing a magnetic field associated with a primary current. The integrated circuit may furthermore be adapted for providing an output signal indicative of the primary current based on the sensed magnetic field. The at least two leads may be adapted for receiving the primary current and the current conductor may be arranged such as to allow an interaction between the magnetic field and the magnetic field sensing circuit.

In an integrated circuit package in accordance with embodiments of the present invention, the magnetic field sensing circuit may comprise at least one Hall sensor.

In an integrated circuit package in accordance with embodiments of the present invention, the magnetic field sensing circuit may comprise at least two magnetic sensors configured to operate in differential mode.

In an integrated circuit package in accordance with embodiments of the present invention, the at least one current conductor may be galvanically insulated from the integrated circuit.

An integrated circuit package in accordance with embodiments of the present invention may further comprise a molding material formed around at least a portion of the lead frame and at least a portion of the semiconductor die to form a molded package body.

In a second aspect, embodiments of the present invention relate to a method for manufacturing an integrated circuit package. The method comprises providing a semiconductor die having first and second opposing surfaces and comprising an integrated circuit, providing a lead frame comprising a plurality of leads and comprising a current conductor forming an electrically conductive path connecting at least two leads of the plurality of leads, providing a groove in each of the at least two leads and arranging the lead frame and the semiconductor die such that the first surface of the semiconductor die is proximate to the current conductor and the second surface is distal from the current conductor. The groove is provided in each of the at least two leads such that the groove locally spaces the lead away from the semiconductor die in a direction perpendicular to the first surface, and such that the groove comprises at least that part of the lead that overlaps the edge of the semiconductor die.

In a method in accordance with embodiments of the present invention, providing the lead frame may comprise providing the lead frame by stamping a metal sheet, thereby forming the groove by offsetting the lead in the groove relative to the lead outside the groove over a predetermined distance in the direction perpendicular to the first surface.

In a method in accordance with embodiments of the present invention, providing the lead frame may comprise providing the lead frame by etching a metal sheet, thereby forming the groove by partially etching away the lead to reduce the height of the lead in the groove relative to the height of the lead outside the groove.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG 1 shows a first exemplary integrated circuit package in accordance with embodiments of the present invention.
FIG 2 shows a section of the first exemplary integrated circuit package in accordance with embodiments of the present invention along the line II-II in FIG 1.
FIG 3 shows a second exemplary integrated circuit package in accordance with embodiments of the present invention.
FIG 4 shows a section of the second exemplary integrated circuit package in accordance with embodiments of the present invention along the line IV-IV in FIG 3.
FIG 5 shows a third exemplary integrated circuit package in accordance with embodiments of the present invention.
FIG 6 shows a cross section of the third exemplary integrated circuit package in accordance with embodiments of the present invention.
FIG 7 provides a detailed schematic view of a central area in an integrated circuit package in accordance with embodiments of the present invention.
FIG 8 provides a detailed schematic view of a central area in an integrated circuit package in accordance with embodiments of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where reference is made in the present description to exemplary current sensors, it is to be understood that, while embodiments of the present invention may be particularly advantageous for application in integrated circuit current sensor packages, embodiments of the present invention may equally relate to other kinds of IC package in which the lead frame design requires good electrical insulation between the lead frame, or at least parts thereof, and the integrated circuit chip.

In a first aspect, the present invention relates to an integrated circuit package comprising a semiconductor die that comprises an integrated circuit and a lead frame. The lead frame comprises a plurality of leads and comprises a current conductor forming an electrically conductive path that connects at least two leads of the plurality of leads, e.g. the current conductor may comprise a coupling of the at least two leads of the plurality of leads. The semiconductor has first and second opposing surfaces, the first surface proximate to the current conductor and the second surface distal from the current conductor. Furthermore, each of the at least two leads comprises a groove to locally space the lead away from the semiconductor die in a direction perpendicular to the first surface. The groove furthermore comprises that part of the lead that overlaps the edge of the semiconductor die.

The integrated circuit package may comprise an insulation structure disposed between the lead frame and the semiconductor die, e.g. at least a portion of the insulation structure may be disposed between at least a part of the lead frame and at least a part of the semiconductor die. The semiconductor die may be oriented parallel to a major surface of the lead frame.

For example, each lead of the at least two leads may comprise a groove where the lead crosses an edge region of the lead frame that is defined by the parallel projection of the circumferential edge of the semiconductor die onto the lead frame in the direction perpendicular to the first surface of the semiconductor die. The groove may locally space the at least one lead away from the semiconductor die, in this edge region, in a direction perpendicular to the first surface, e.g. such as to prevent electrical breakdown of the insulation structure and/or partial discharge near the edge of the semiconductor die.

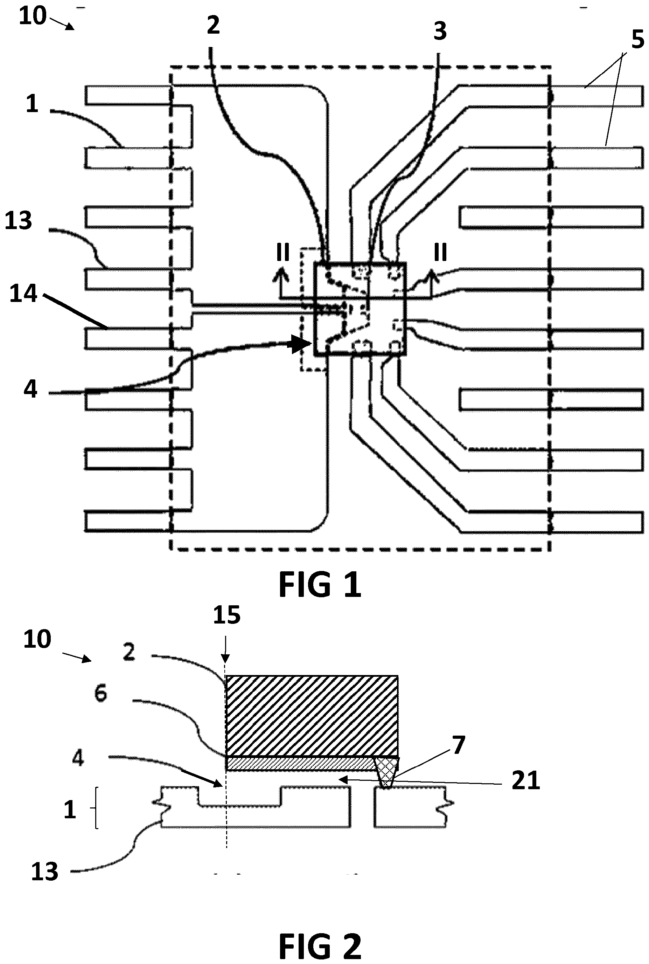

Referring to FIG 1, an integrated circuit package 10 in accordance with embodiments of the present invention is schematically illustrated. FIG 2 illustrates a section taken along the line II-II in FIG 1. The integrated circuit package may be a semiconductor die package.

The integrated circuit package 10 comprises a semiconductor die 2 that comprises an integrated circuit.

For example, the integrated circuit package may comprise a current sensor, e.g. may be a current sensor. The integrated circuit of the semiconductor die 2 may comprise a magnetic field sensing circuit 3 on a surface of the semiconductor die proximal to the lead frame, e.g. on a surface of the die facing the lead frame. Alternatively, the integrated circuit of the semiconductor die 2 may comprise a magnetic field sensing circuit 3 on a surface of the semiconductor die distal to the lead frame, e.g. on a surface of the die facing away from the lead frame.

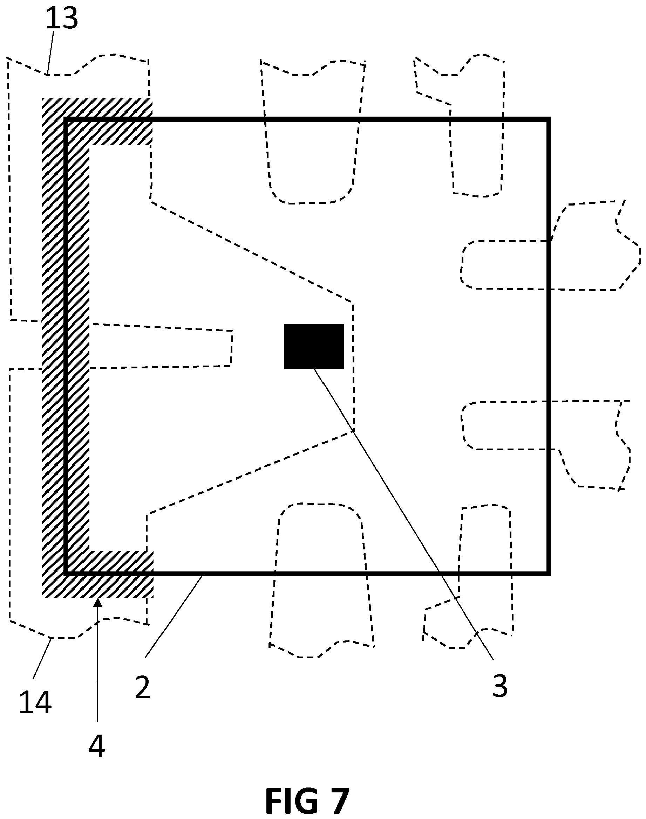

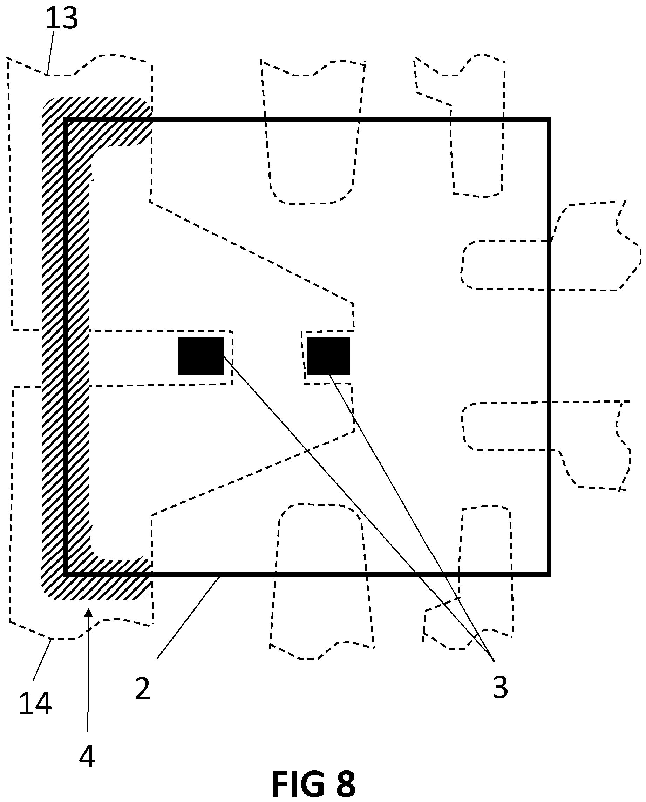

For example, FIG 7 and FIG 8 provide more detailed schematic views of a central area around the semiconductor die 2, in an exemplary embodiment similar to that shown in FIG 1, showing an exemplary magnetic field sensing circuit 3.

This magnetic field sensing circuit may be adapted for sensing a magnetic field associated with a primary current. Furthermore, the integrated circuit may be adapted for providing an output signal indicative of this primary current based on the sensed magnetic field. For example, the plurality of leads may comprise at least one signal lead coupled to the semiconductor die by an electrical interconnect, e.g. by a solder metal bump 7, and the integrated circuit of the semiconductor die may be adapted for outputting the output signal via the at least one signal lead.

For example, the magnetic field sensing circuit may comprise one or more magnetic sensors, such as Hall sensors. For example, a plurality of magnetic sensors, e.g. at least two magnetic sensors may be operated in differential mode. However, embodiments of the present invention are not limited thereto.

The magnetic field sensing circuit 3 may comprise at least one magnetoresistive sensor, e.g. an anisotropic magnetoresistance (AMR) sensor, a giant magnetoresistance (GMR) sensor, a colossal magnetoresistance (CMR) sensor, a tunnel magnetoresistance (TMR) sensor and/or an extraordinary magnetoresistance (EMR) sensor.

The magnetic field sensing circuit 3 may comprise at least one Hall sensor, e.g. one or more planar Hall sensors and/or one or more vertical Hall sensors. For example, the at least one Hall sensor may be sensitive along an axis perpendicular to the surface of the semiconductor die.

The integrated circuit package 10 comprises a lead frame 1. The lead frame may be a conductive structure, e.g. a metal structure, such as a copper or copper alloy structure. For example, the lead frame may be formed by selectively removing material from a flat metal plate, e.g. by etching and/or stamping. The lead frame may be provided in the integrated circuit package to enable a signal exchange between the semiconductor and the outside, e.g. by providing external connectors conductively connected to the integrated circuit.

The lead frame may comprise a plurality of separate structures, for example a primary lead frame and a secondary lead frame. The lead frame may comprise a die attach surface. The lead frame 1, or a part thereof, such as a secondary lead frame part thereof, may be attached, e.g. directly or indirectly attached, to the semiconductor die 2. For example, the semiconductor die may be glued to the lead frame. For example, the secondary lead frame may comprise signal leads connected to the integrated circuit, while the primary lead frame may comprise the current conductor forming the electrically conductive path connecting the least two leads 13,14 of the plurality of leads, e.g. such as to electrically isolate the current conductor from the integrated circuit and from the secondary lead frame.

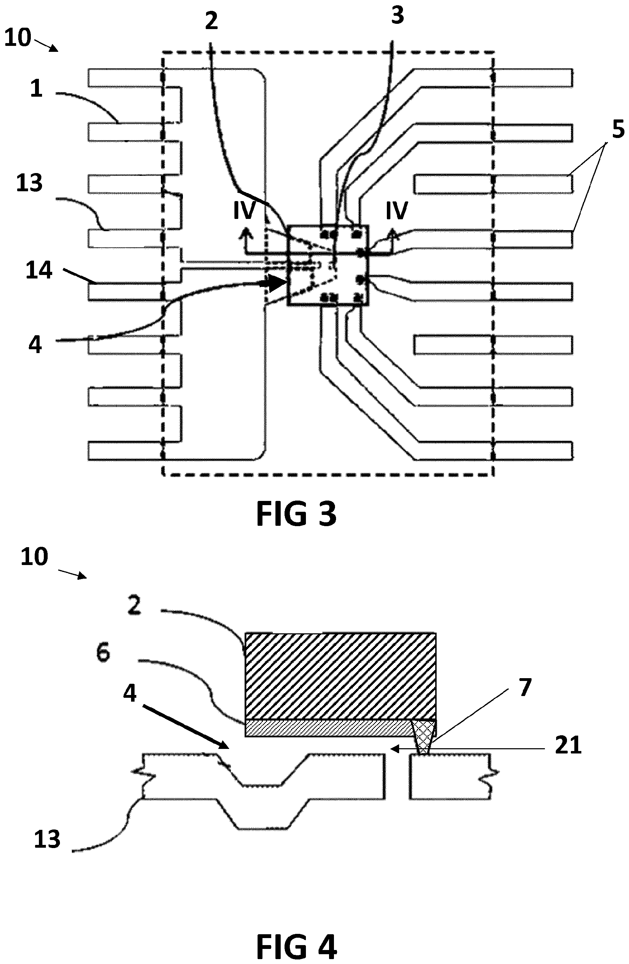

A mechanical and electrical connection may be established between the semiconductor die and the lead frame, of a part thereof, e.g. electrically connecting a lead of the lead frame, e.g. of the secondary lead frame part, to the integrated circuit. For example, the lead frame may be attached by solder metal bumps 7 to the semiconductor die. Furthermore, the insulation structure may provide a mechanical connection between the semiconductor die and the lead frame. However, the insulation structure does not necessarily comprise such mechanical connection, e.g. does not necessarily have a substantial structural support function. For example, a secondary lead frame may be connected to the semiconductor die by solder metal bumps 7 for connecting signal leads to the integrated circuit. These solder metal bumps 7 may provide both electrical connections and mechanical support to the integrated circuit. Furthermore, dummy metal bumps may additionally be provided to support the die mechanically, without also providing a functional electrical connection. Furthermore, a gap 21 may separate the semiconductor die, e.g. the integrated circuit, from at least part of the lead frame, e.g. from a primary lead frame part forming the primary current conductor, e.g. as shown in FIG 2 and FIG 4.

Thus, the integrated circuit may be provided on the side of the semiconductor die facing the lead frame, and electrical connections may be established between die attach pads and leads of the lead frame via solder bumps. However, embodiments of the present invention are not necessarily limited thereto. For example, die pads may be connected to the leads by bond wires. Particularly, the at least two leads of the plurality of leads, electrically connected to each other by a current conductor of the lead frame, may not be electrically connected to the semiconductor die at all, e.g. may be electrically isolated from the semiconductor die.

The lead frame further comprises a plurality of leads 5, e.g. electrically conductive leads, that may end in external lead connectors.

The plurality of leads may comprise at least one signal lead coupled to the semiconductor die by an electrical interconnect, e.g. by a solder metal bump 7.

The lead frame 1 further comprises a current conductor forming an electrically conductive path connecting at least two leads 13,14 of the plurality of leads. For example, the lead frame may comprise at least one current conductor having at least two end regions formed by at least two leads 13,14 of the plurality of leads for receiving the primary current referred to hereinabove, e.g. such that the integrated circuit can generate an output signal indicative of the primary current based on the sensed magnetic field when this primary current is applied between the at least two leads. The lead frame may also comprise a central region arranged such as to allow an interaction between the magnetic field, associated with the primary current when conducted by the current conductor, and the magnetic field sensing circuit 3.

The current conductor, or each of the at least one current conductor, may be formed by a conductive part of the lead frame connecting the at least two leads to form a current path short-cutting the at least two leads. For example, in accordance with embodiments of the present invention, a magnetic field sensing circuit 3, such as one or more Hall sensors, may be sensitive, e.g. maximally sensitive, along an axis perpendicular to the surface of the semiconductor die, and the conductive part may be positioned to intersect this axis of the magnetic field sensing circuit 3.

The integrated circuit package 10 may further comprise an insulation structure, e.g. comprising an electrically insulating material, disposed between the lead frame 1 and the semiconductor die 2. For example, at least a portion of the insulation structure is disposed between at least a part of the lead frame and at least a part of the semiconductor die. For example, the insulation structure may comprise an on-chip passivation layer covering a surface of the die facing the lead frame.

In accordance with embodiments of the present invention, the semiconductor die may be electrically insulated from the primary current conductor by a gap 21, e.g. a vacuum or gas-filled gap, e.g. an air-filled gap, between the semiconductor die and at least a part of the lead frame, e.g. a primary lead frame part forming the primary current conductor. This gap 21 may be wider near an edge of the semiconductor circuit, e.g. where on-chip passivation may be less effective, due to the groove 4, compared to the gap distance in a region near the magnetic field sensing unit 3.

The at least one current conductor, referred to hereinabove, may be electrically insulated from the integrated circuit by an insulation structure.

The insulation structure may comprise a passivation layer 6 of the semiconductor die that covers a side of the semiconductor die that faces the lead frame 1. For example, such passivation layer 6 may comprise a polyimide and/or silicon oxide passivation layer.

The insulation structure may also comprise a molding material, e.g. a plastic molded material. For example, the lead frame may be molded in a plastic case for insulation. The molding material may be formed around at least a portion of the lead frame and at least a portion of the semiconductor die to form a molded package body.

For example, in accordance with embodiments of the present invention, a distance representative of an electrical breakdown safety margin may be introduced between the at least two leads 13,14 of the lead frame, e.g. forming the current conductor, and the edge of the semiconductor die. Furthermore, a small clearance between the lead frame current conductor and components of the integrated circuit may be maintained, e.g. for allowing a magnetic sensing element to sense a magnetic field associated with a current flowing through the current conductor. Maintaining a small distance between the current conductor and the integrated circuit may advantageously provide a good sensitivity in sensing the current, e.g. by the magnetic sensing element. Embodiments of the present invention advantageously allow a good voltage isolation, e.g. may allow an increased voltage isolation when compared to a similar device known in the art, without compromising the sensitivity by increasing the clearance distance.

The clearance between the lead frame and the semiconductor die may be filled in with a plastic compound as an insulator medium, e.g. by the molding material of the insulation structure. However, other embodiments of the present invention may not require such plastic compound in between the lead frame and the semiconductor die.

Embodiments of the present invention may advantageously allow to increase the voltage isolation, e.g. compared to a prior-art device, while not compromising the sensitivity of a magnetic sensor for determining a current conducted by the current conductor in the lead frame, e.g. while not comprising such sensitivity by increasing the distance between the current conductor and the sensing element.

The semiconductor die 2 is oriented parallel to the die attach surface 11 and positioned directly above the die attach region 12 such that the edges of the die attach region 12 are aligned with the edges of the semiconductor die 2, or otherwise said, the die attach region is defined by the projection of the semiconductor die onto the die attach surface in a projection direction perpendicular to the die attach surface.

The semiconductor die 2 has a first surface and a second surface opposing the first surface, in which the first surface is proximate to the current conductor and the second surface is distal from the current conductor.

Furthermore, each of the at least two leads 13, 14 comprises a groove 4 to locally space the lead away from the semiconductor die in a direction perpendicular to the first surface.

This groove 4 comprises at least that part of the lead that overlaps the edge of the semiconductor die, e.g. the intersection of the lead and the edge of the die when viewed by a parallel projection in the direction perpendicular to the first surface. For example, the groove 4 may comprise at least that part of the lead that crosses underneath the edge of the semiconductor die.

The groove 4 may be provided under at least part of one or more edges of the semiconductor die. In a plane parallel to the semiconductor die, corners of the groove may be formed substantially at substantially right angles, e.g. as shown in FIG 7, or may comprise rounded corners, e.g. as shown in FIG 8.

For example, the groove 4 may overlap the edge of the semiconductor die in a part of the lead where the primary current conductor formed by the lead is wider (e.g. when viewed in a plane parallel to the semiconductor die) than in a part of the lead nearer to a magnetic field sensing unit 3. Thus the current density in the grooved part of the lead may be lower than in an ungrooved part closer to the magnetic field sensing unit, e.g. thus contributing to a good electrical isolation between the semiconductor die and the primary current conductor.

The at least two leads 13, 14 may be adapted for receiving the primary current, referred to hereinabove, e.g. may form the at least two end regions of the at least one current conductor, also referred to hereinabove.

The lead frame, or the part of the lead frame forming the at least two leads 13,14 and the at least one current conductor, may, for example, have a thickness in the range of 40 µm to 400 µm, e.g. 50 µm to 300 µm, e.g. 100 µm to 200 µm.

Each of the at least two leads 13,14 may thus be spaced away from the semiconductor die 2, in the grooved part of the lead, in a direction perpendicular to the die attach surface 11, e.g. such as to prevent electrical breakdown of the insulation structure near the edge of the die, for example to prevent electrical breakdown of the insulation structure by forming an electrical breakdown path through the insulation structure or around an edge of the insulation structure that would conductively connect the lead 13,14 to the semiconductor die 2.

For example, the groove may locally space the grooved part of the leads 13.14 at least 10 µm, e.g. at least 20 µm, farther away from the die than a part of the leads 13,14 that is outside the groove, e.g. than a part of the current conductor that is arranged in close proximity to the magnetic sensing element 3.

The groove 4 in the at least two leads 13,14 may, for example, comprise a depression such as a narrow depression or a trough-like deformation. Thus, a channel, hollow, cut and/or indentation may be formed in the surface of the lead 13,14 that faces the semiconductor die, e.g. at a position directly underneath the edge of the semiconductor die. For example, this groove may have a V-shaped or U-shaped profile along the longitudinal direction of the lead.

The height of the lead may be reduced in the groove 4, relative to the height of the lead outside the groove. These heights may refer to a height measured in a direction perpendicular to the first surface. For example, this height may be reduced to a height in the range of 1% to 75%, e.g. in the range of 10% to 70%, e.g. 20% to 60%, e.g. in the range of 30% to 50%, such as about 50%, e.g. 50%, of the height of the lead outside the groove.

In the groove 4, the lead 13,14 may be partially etched away such that the material of an upper part of the lead in this groove was removed during manufacture, in which the 'upper part' refers to a part that is proximal to the semiconductor die, as illustrated in FIG 2. Thus, a bottom surface of the lead 13,14 may be substantially smooth and/or substantially flat in the groove and around the grooved region, while a top surface of the lead 13,14 may be indented to form the groove, in which the 'top surface' refers to the surface proximal to the semiconductor die and the 'bottom surface' refers to the surface distal to the semiconductor die. Thus, the lead 13,14 may be formed by a partially etched, e.g. a half-etched, lead frame design.

Referring to FIG 3 and FIG 4, another exemplary integrated circuit package 10 is shown. Where in the example shown in FIG 1 and FIG 2, the groove 4 may be obtainable by applying an etching technique to the lead frame, e.g. to obtain the partially etched groove in the lead frame design described hereinabove, FIG 3 and FIG 4 illustrate another exemplary embodiment in which the groove may be produced by locally down-setting the lead in the groove region, e.g. using a stamping technique.

The height of the at least two leads 13,14 may be substantially constant, e.g. in the groove as compared to outside the groove. However, a portion of the lead may be displaced, e.g. offset, over a predetermined distance in the direction perpendicular to the die attach surface such as to form the groove 4. For example, this predetermined distance may be in the range of 1% to 90%, e.g. in the range of 10% to 85%, e.g. 25% to 60%, such as 50%, e.g. in the range of 60% to 80%, such as 75%, of the height of the at least two leads 13,14.

Thus, both the bottom surface and the top surface of the lead 13,14 may be indented to form the groove, in which the 'top surface' refers to the surface proximal to the semiconductor die and the 'bottom surface' refers to the surface distal to the semiconductor die. Thus, the at least one lead 13,14 may be formed by a stamped lead frame design.

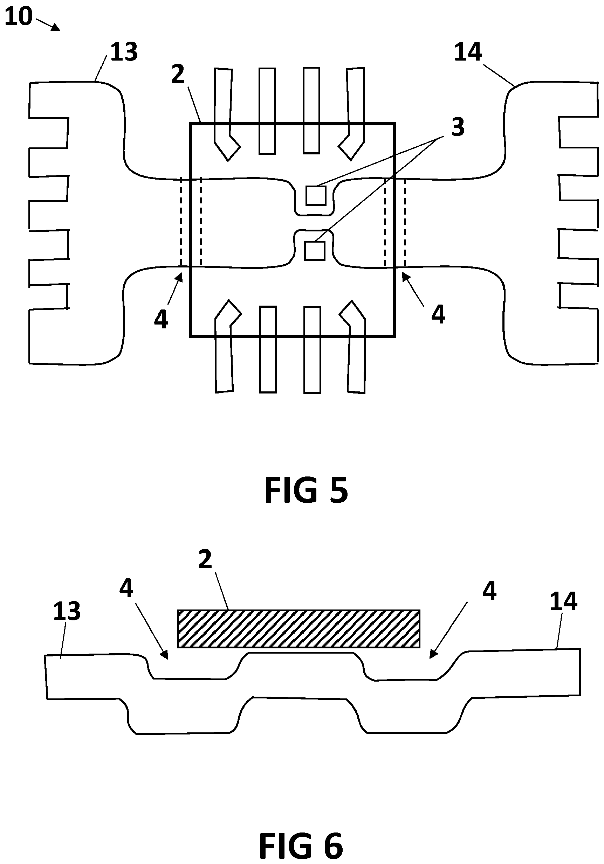

In an integrated circuit package in accordance with embodiments of the present invention, the current conductor forming the electrically conductive path connecting the at least two leads 13,14 may be curved, e.g. as shown in FIG 1 and FIG 3. However, in other embodiments of the present invention, the current conductor of the lead frame may be substantially straight, e.g. may electrically connect at least two leads 13,14 that extend toward the integrated circuit from opposite edges of the semiconductor die. For example, such arrangement is illustrated in FIG 5 and FIG 6.

In a second aspect, the present invention relates to a method for manufacturing an integrated circuit package, e.g. an IC package in accordance with embodiments of the first aspect of the present invention, such as a current sensor, for example as described hereinabove.

The method comprises providing a semiconductor die having first and second opposing surfaces, in which the semiconductor die comprises an integrated circuit, e.g. as described hereinabove in relation to embodiments of the first aspect of the present invention.

The method further comprises providing a lead frame that comprises a plurality of leads. The lead frame also comprises a current conductor forming an electrically conductive path connecting at least two leads of the plurality of leads,

The method also comprises providing a groove in each of the at least two leads.

The method further comprises arranging the lead frame and the semiconductor die such that the first surface of the semiconductor die is proximate to the current conductor and the second surface is distal from the current conductor. For example, the method may comprise attaching the lead frame to the semiconductor die, e.g. such that the semiconductor die is oriented parallel to the lead frame.

The method may also comprise providing an insulation structure between the lead frame and the semiconductor die. This may comprise providing a passivation layer on the semiconductor die, e.g. on the first surface thereof. The method may also comprise providing a molding material between and/or around the lead frame and the semiconductor die.

The groove is provided in each of the at least two leads such that the groove locally spaces the lead away from the semiconductor die in a direction perpendicular to the first surface, and such that the groove comprises at least that part of the lead that overlaps the edge of the semiconductor die.

For example, the at least two leads may be adapted for conducting a primary current of a current sensor that, in operation of the device, is brought in close proximity to a magnetic sensing element of the integrated circuit in order to characterize this primary current. For example, the at least two leads may be adapted for conducting a large current or for receiving a large voltage. For example, the current sensor may be adapted for safely determining a current in the primary conductor while allowing a peak current, in operation, of, for example, 200 A, or a nominal current, in operation, of 100 A. For example, the current sensor may be adapted for receiving high voltages, e.g. 500 V, e.g. 1000 V, e.g. 2000 V.

In a method in accordance with embodiments of the present invention, the lead frame may be provided by stamping a metal sheet, thereby forming the groove by offsetting the lead in the groove, relative to that lead outside the groove, over a predetermined distance in the direction perpendicular to the first surface. Thus, a stamped tool may be used to create a downset feature in a predetermined area of leads forming part of a current conductor in the lead frame. For example, such downset feature may be located at the portion of the lead frame current conductor that is parallel with the edge of the integrated circuit. Thus, a safe clearance between the edge of the integrated circuit chip and the lead in the lead frame can be achieved, e.g. at the edge where the integrated circuit might be less protected by chip passivation.

In a method in accordance with embodiments of the present invention, the lead frame may be provided by etching a metal sheet, e.g. by using chemical etching, thereby forming the groove by partially etching away the lead to reduce the height of the lead in the groove, relative to the height of that lead outside the groove. For example, as illustrated in FIG 2, the partial etching, e.g. half-etching, may cover the portion of the leads in the lead frame that forms a current conductor, e.g. for conducting a current to be sensed in a current sensor. The etched groove may be parallel with the edge of the integrated circuit. Thus, a safe clearance between the edge of the integrated circuit and the current conductor can be provided, e.g. at edges where the integrated circuit is less protected by chip passivation.

## Claims

1. An integrated circuit package (10) comprising:
a lead frame (1) having a plurality of leads and having a current conductor forming an electrically conductive path connecting at least two leads (13,14) of the plurality of leads, and
a semiconductor die (2) comprising an integrated circuit and having first and second opposing surfaces, the first surface proximate to the current conductor and the second surface distal from the current conductor,
wherein each lead of said at least two leads comprises a groove (4) to locally space said lead away from the semiconductor die in a direction perpendicular to said first surface, wherein said groove (4) comprises at least that part of said lead that overlaps the edge of the semiconductor die.

2. The integrated circuit package of claim 1, wherein said groove (4) has a V-shaped or U-shaped profile along the longitudinal direction of said lead (13,14).

3. The integrated circuit package of any of the previous claims, in which said groove (4) is formed by a reduced height of the lead relative to the height of said lead outside the groove (4).

4. The integrated circuit package of claim 3, wherein a top surface of each of the at least two leads (13,14) is indented such as to form said groove (4), said top surface being proximal to the semiconductor die.

5. The integrated circuit package of claim 1 or claim 2, in which each of the at least two leads (13,14) is offset in the groove (4), relative to the lead (13,14) outside the groove, over a predetermined distance in said direction perpendicular to the first surface.

6. The integrated circuit package of any of the previous claims, in which the semiconductor die further comprises a passivation layer on said first surface.

7. The integrated circuit package of claim 6, wherein said passivation layer comprises a polyimide passivation layer.

8. The integrated circuit package of any of the previous claims, said integrated circuit package being a current sensor, wherein said integrated circuit of the semiconductor die (2) comprises a magnetic field sensing circuit (3), said magnetic field sensing circuit being adapted for sensing a magnetic field associated with a primary current, said integrated circuit being furthermore adapted for providing an output signal indicative of said primary current based on said sensed magnetic field, wherein said at least two leads are adapted for receiving said primary current and said current conductor is arranged such as to allow an interaction between said magnetic field and said magnetic field sensing circuit (3).

9. The integrated circuit package of claim 8, wherein said magnetic field sensing circuit (3) comprises at least one Hall sensor.

10. The integrated circuit package of claim 8 or claim 9, wherein said magnetic field sensing circuit comprises at least two magnetic sensors configured to operate in differential mode.

11. The integrated circuit package of any of claims 8 to 10, wherein said at least one current conductor is galvanically insulated from the integrated circuit.

12. The integrated circuit package of any of the previous claims, further comprising a molding material formed around at least a portion of the lead frame and at least a portion of the semiconductor die to form a molded package body.

13. A method for manufacturing an integrated circuit package, the method comprising:
- providing a semiconductor die (2) having first and second opposing surfaces and comprising an integrated circuit;
- providing a lead frame (1) comprising a plurality of leads (5) and comprising a current conductor forming an electrically conductive path connecting at least two leads (13,14) of the plurality of leads,
- providing a groove (4) in each of the at least two leads (13,14) ; and
- arranging said lead frame and said semiconductor die such that the first surface of the semiconductor die is proximate to the current conductor and the second surface is distal from the current conductor,
wherein said groove (4) is provided in each of the at least two leads (13,14) such that said groove locally spaces the lead away from the semiconductor die in a direction perpendicular to said first surface, and such that said groove (4) comprises at least that part of the lead that overlaps the edge of the semiconductor die.

14. The method of claim 13, wherein providing the lead frame comprises providing the lead frame by stamping a metal sheet, thereby forming said groove by offsetting said lead in the groove relative to said lead outside the groove over a predetermined distance in the direction perpendicular to the first surface.

15. The method of claim 13, wherein providing the lead frame comprises providing the lead frame by etching a metal sheet, thereby forming the groove by partially etching away said lead to reduce the height of said lead in the groove relative to the height of said lead outside the groove.
